# EUROPEAN PATENT SPECIFICATION

(11) **EP 3 945 575 B1**
(45) Date of publication and mention of the grant of the patent: **18.12.2024**
(21) Application number: 21188162.8
(22) Date of filing: 28.07.2021
(51) Int. Cl.: H01L 25/075, H01L 33/48, H01L 33/50

(54) **LIGHTING APPARATUS**
BELEUCHTUNGSVORRICHTUNG
APPAREIL D'ÉCLAIRAGE

(30) Priority: 31.07.2020 CN 202021576106 U
(43) Date of publication of application: 02.02.2022
(73) Proprietor: LEEDARSON LIGHTING CO., LTD., Changtai, Zhangzhou Fujian 363999 (CN)
(72) Inventor: WU, Yunbiao, Changtai, Zhangzhou, CN-363999 (CN); DONG, Yongzhe, Changtai, Zhangzhou, CN-363999 (CN); ZHANG, Lei, Changtai, Zhangzhou, CN-363999 (CN); XIE, Zhirong, Changtai, Zhangzhou, CN-363999 (CN); LIN, Ruixiang, Changtai, Zhangzhou, CN-363999 (CN)
(74) Representative: Leihkauf, Steffen Falk

(56) References cited:
- EP-A1- 3 684 143
- US-A1- 2009 050 908
- US-A1- 2013 229 125
- US-A1- 2013 301 257
- US-A1- 2019 057 954
- US-A1- 2019 281 679

## Description

### FIELD

The present invention is related to a lighting apparatus, and more particularly related to a lighting apparatus with multiple LED packages.

### BACKGROUND

The time when the darkness is being lighten up by the light, human have noticed the need of lighting up this planet. Light has become one of the necessities we live with through the day and the night. During the darkness after sunset, there is no natural light, and human have been finding ways to light up the darkness with artificial light. From a torch, candles to the light we have nowadays, the use of light have been changed through decades and the development of lighting continues on.

Early human found the control of fire which is a turning point of the human history. Fire provides light to bright up the darkness that have allowed human activities to continue into the darker and colder hour of the hour after sunset. Fire gives human beings the first form of light and heat to cook food, make tools, have heat to live through cold winter and lighting to see in the dark.

Lighting is now not to be limited just for providing the light we need, but it is also for setting up the mood and atmosphere being created for an area. Proper lighting for an area needs a good combination of daylight conditions and artificial lights. There are many ways to improve lighting in a better cost and energy saving. LED lighting, a solid-state lamp that uses light-emitting diodes as the source of light, is a solution when it comes to energy-efficient lighting. LED lighting provides lower cost, energy saving and longer life span.

The major use of the light emitting diodes is for illumination. The light emitting diodes is recently used in light bulb, light strip or light tube for a longer lifetime and a lower energy consumption of the light. The light emitting diodes shows a new type of illumination which brings more convenience to our lives. Nowadays, light emitting diode light may be often seen in the market with various forms and affordable prices.

After the invention of LEDs, the neon indicator and incandescent lamps are gradually replaced. However, the cost of initial commercial LEDs was extremely high, making them rare to be applied for practical use. Also, LEDs only illuminated red light at early stage. The brightness of the light only could be used as indicator for it was too dark to illuminate an area. Unlike modern LEDs which are bound in transparent plastic cases, LEDs in early stage were packed in metal cases.

In 1878, Thomas Edison tried to make a usable light bulb after experimenting different materials. In November 1879, Edison filed a patent for an electric lamp with a carbon filament and keep testing to find the perfect filament for his light bulb. The highest melting point of any chemical element, tungsten, was known by Edison to be an excellent material for light bulb filaments, but the machinery needed to produce super-fine tungsten wire was not available in the late 19th century. Tungsten is still the primary material used in incandescent bulb filaments today.

Early candles were made in China in about 200 BC from whale fat and rice paper wick. They were made from other materials through time, like tallow, spermaceti, colza oil and beeswax until the discovery of paraffin wax which made production of candles cheap and affordable to everyone. Wick was also improved over time that made from paper, cotton, hemp and flax with different times and ways of burning. Although not a major light source now, candles are still here as decorative items and a light source in emergency situations. They are used for celebrations such as birthdays, religious rituals, for making atmosphere and as a decor.

Illumination has been improved throughout the times. Even now, the lighting device we used today are still being improved. From the illumination of the sun to the time when human can control fire for providing illumination which changed human history, we have been improving the lighting source for a better efficiency and sense. From the invention of candle, gas lamp, electric carbon arc lamp, kerosene lamp, light bulb, fluorescent lamp to LED lamp, the improvement of illumination shows the necessity of light in human lives.

There are various types of lighting apparatuses. When cost and light efficiency of LED have shown great effect compared with traditional lighting devices, people look for even better light output. It is important to recognize factors that can bring more satisfaction and light quality and flexibility.

Panel ight devices are widely used in various environment. Panel light devices usually have smaller thickness.

People like to have flexible control over panel light devices. For example, people like to change color temperatures or other parameters of panel light device to fit their needs. EP3684143 A1 and US2019057954 A1 present prior art lighting devices with controllable color temperatures.

Therefore, it is beneficial to provide a novel design with flexible and convenient way to adjust parameters of panel light devices.

### SUMMARY

In the following some embodiments (examples) are described. The invention is however only as defined in the appended claims.

In some embodiments, a lighting apparatus includes a light source plate, multiple light modules and a driver.

Multiple light modules are placed on the light source plate.

Each light module includes a LED package and a lens.

The LED package includes multiple sections.

At least a LED unit is placed in each section.

Each section has a pair of corresponding LED electrodes.

The driver is electrically connected to the LED electrodes for supplying an adjustable ratio of separate driving currents to the LED electrodes to generate a required light parameter by mixing multiple lights emitted by the LED units disposed in the sections of the light modules.

The lens has multiple lens areas for guiding lights of different sections in each light module to generate a mixed light via the lens.

In some embodiments, the LED package has a first section and a second section.

A first LED unit is placed in the first section covered with a first fluorescent layer. A second LED unit is place in the second section covered with a second fluorescent layer.

The first fluorescent layer and the second fluorescent layer have different compositions.

In some embodiments, the LED package has a package housing and a spacer wall.

The spacer wall separates the first section and the second section.

In some embodiments, the packaging housing has tilt bases for respectively placing the first LED unit and the second LED unit so that lights of the first LED unit and the second LED unit overlaps more than 50 percent in the lens.

In some embodiments, the first LED unit has at least one first type LED chip and one second type LED chip.

The second LED unit has at least one first type LED chip and one second type LED chip.

The driver adjusts the adjustable ratio of separate driving currents to generate the required light parameter.

In some embodiments, the LED package has a circular external shape.

In some embodiments, the first section is semi-circular shape and the second section is semi-circular shape.

In some embodiments, the light module has an aligning structure for aligning the lens with the LED package.

In some embodiments, the lens has a convex external curve surface.

In some embodiments, the lens has a concave curve inner dome facing to the LED package.

In some embodiments, the lens has multiple micro lenses for guiding lights of different sections to generate the mixed light via the lens.

In some embodiments, the lens has a package connector for aligning and coupling the LED package.

In some embodiments, the light source plate has multiple grooves for placing multiple light strips, the multiple light modules are placed on the light strips.

In some embodiments, the lighting apparatus may also include a light passing cover connected to the light source plate forming a container for enclosing the multiple light modules.

In some embodiments, the light passing cover has multiple cover lenses corresponding to the multiple light strips.

In some embodiments, the light strips are detachable to be replaced from the light source plate.

In some embodiments, the lens has a plugging structure for plugging on the light strip.

In some embodiments, the LED package is electrically connected to the driver when the lens is plugged on the light strip.

In some embodiments, the sections of the light modules are divided into a first group and a second group.

The LED electrodes of the sections of the first group and the LED electrodes of the sections of the second group are separately electrically connected to the driver.

In some embodiments, the first group is connected to a first connector and the second group is connected to a second connector.

The driver determines types of the first connector and the second connector to supply corresponding driving currents to the first group and the second group separately.

### BRIEF DESCRIPTION OF DRAWINGS

Fig. 1 illustrates a LED package example.
Fig. 2 illustrates a package housing example in Fig. 1.
Fig. 3 illustrates a top view of a LED package example.
Fig. 4 illustrates a light module example.
Fig. 5 illustrates a top view of the example in Fig. 4.
Fig. 6 illustrates a panel light device example.
Fig. 7 illustrates a lighting apparatus embodiment.
Fig. 8 illustrates a light mixing scheme.
Fig. 9 illustrates a driver connection example.
Fig. 10 illustrates a structure of another embodiment.

### DETAILED DESCRIPTION

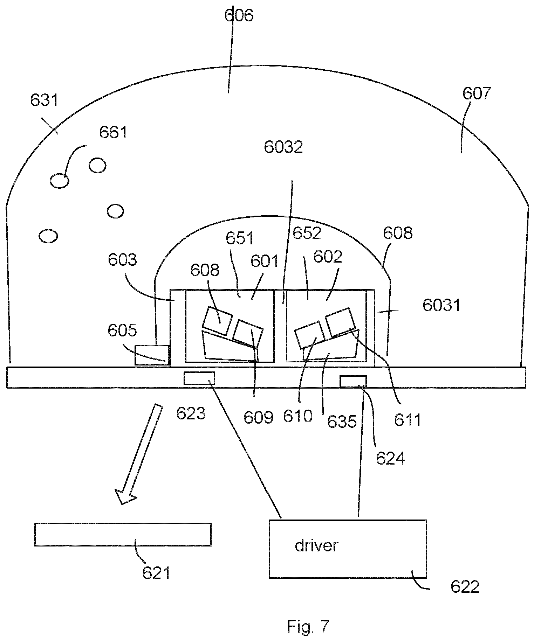

In Fig. 7, a lighting apparatus includes a light source plate 621, multiple light modules 631 and a driver 622. In Fig. 7, the light source plate 621 is illustrated with a minimized form for explaining the relation among components, not the actual ratio among components.

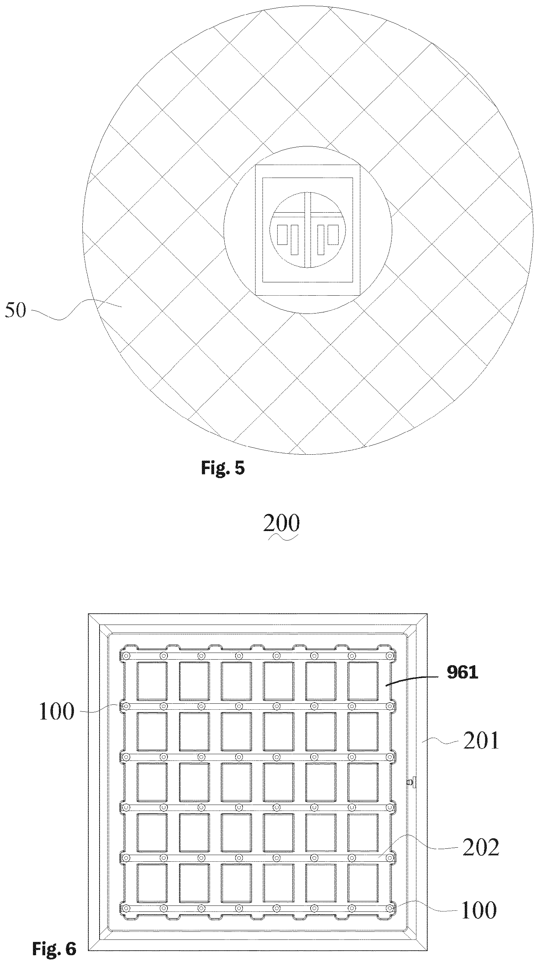

Multiple light modules 631 are placed on the light source plate 621. In some embodiments, the light modules 631 are integrated on light strips placed on a plate as shown in Fig. 6.

Each light module 631 includes a LED package 603 and a lens 606.

The LED package 603 includes multiple sections, e.g. a first section 601 and a second section 602.

At least a LED unit is placed in each section. The LED unit may have one or more LED chips. For example, the LED unit in the first section 601 has a first type LED chip 608 and a second type LED chip 609. The LED unit in the second section 602 has a first type LED chip 611 and a second LED type chip 610. The first type LED chip may have a different color temperature as the second type LED chip. But, the first type LED chip in the first section 601 may have a smaller size than the second type LED chip in the second section 602.

By changing a relative ratio of driving currents supplied to the first section and the second section, a different color temperature is obtained.

Each section 601, 602 has a pair of corresponding LED electrodes 623, 624 so that the two sections are controlled separately by the driver 622. For example, the driver 622 may supply different driving currents volumes to the two sections 601, 602 to mix a required light parameter.

The driver is electrically connected to the LED electrodes for supplying an adjustable ratio of separate driving currents to the LED electrodes to generate a required light parameter by mixing multiple lights emitted by the LED units disposed in the sections of the light modules 631.

The lens has multiple lens areas for guiding lights of different sections in each light module to generate a mixed light via the lens.

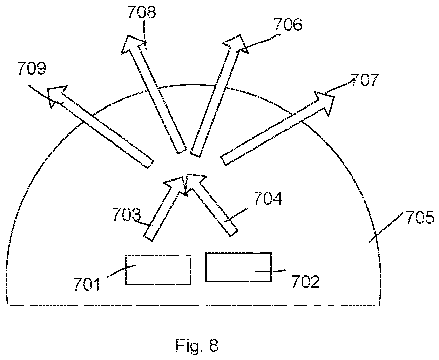

Fig. 8 shows an example of mixing lights by a lens. In Fig. 8, two LED units 701, 702 emit lights 703, 704 with an overlapping angle. The lens 705 further guides direction of the light 703, 704 to lights 706, 707, 708, 709 to diffuse and mix the lights 703, 704 evenly.

In some embodiments, the LED package has a first section and a second section.

In Fig. 7, a first LED unit is placed in the first section covered with a first fluorescent layer 651. A second LED unit is place in the second section 602 covered with a second fluorescent layer 652.

The first fluorescent layer 651 and the second fluorescent layer 652 have different compositions. For example, different chemical fluorescent material are filled in the first section 601 and the second section 602 to get required output light parameters.

In some embodiments, the LED package 603 has a package housing 6031 and a spacer wall 6032.

The spacer wall 6032 separates the first section 601 and the second section 602.

In some embodiments, the packaging housing has tilt bases 635 for respectively placing the first LED unit and the second LED unit so that lights of the first LED unit and the second LED unit overlaps more than 50 percent in the lens. In other words, most of lights are overlapped in the lens 606.

In some embodiments, the first LED unit has at least one first type LED chip and one second type LED chip.

The second LED unit has at least one first type LED chip and one second type LED chip.

The driver adjusts the adjustable ratio of separate driving currents to generate the required light parameter.

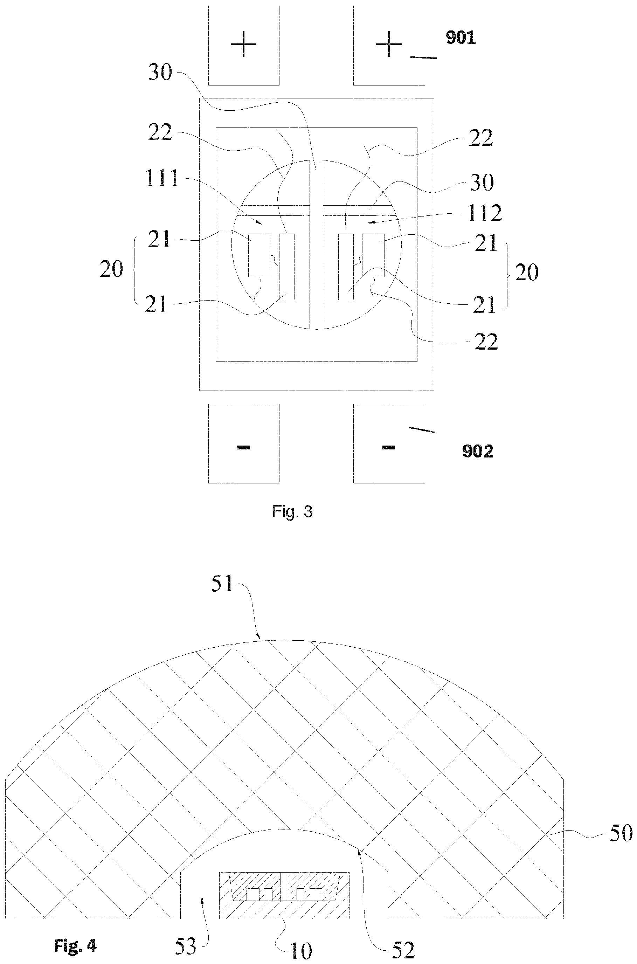

In some embodiments, the LED package has a circular external shape, as shown in Fig. 4 and Fig. 5.

In some embodiments, the first section is semi-circular shape and the second section is semi-circular shape, as shown in Fig. 5.

In some embodiments, the light module has an aligning structure 605 for aligning the lens with the LED package. For example, the LED package has a structure protruding pin and the lens has a socket corresponding to the protruding pin to align the lens and the LED package so as to diffuse light as planned.

In some embodiments, the lens has a convex external curve surface 607, e.g. the top exterior surface of the lens 606.

In some embodiments, the lens has a concave curve inner dome 608 facing to the LED package.

In some embodiments, the lens has multiple micro lenses 661 for guiding lights of different sections to generate the mixed light via the lens. Specifically, the lens may have a different way of design, by placing multiple micro lenses to guide lights in various directions.

In some embodiments, the lens has a package connector for aligning and coupling the LED package, like the aligning structure 605, but may have an attaching structure to combine the two components.

In some embodiments, the light source plate has multiple grooves for placing multiple light strips, the multiple light modules are placed on the light strips, as shown in Fig. 6. There is a light source plate 201 with grooves as an array for placing light strips 202 mounted with light modules 100.

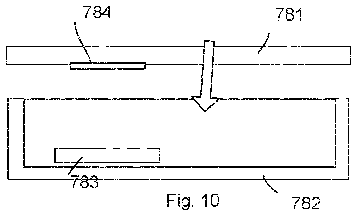

In Fig. 10, the lighting apparatus may also include a light passing cover 781 connected to the light source plate 782 forming a container for enclosing the multiple light modules.

In some embodiments, the light passing cover has multiple cover lenses 784 corresponding to the multiple light strips 783.

In some embodiments, the light strips are detachable to be replaced from the light source plate. For example, the light strip may have a plug structure like a traditional light tube.

In some embodiments, the lens has a plugging structure for plugging on the light strip.

In some embodiments, the LED package is electrically connected to the driver when the lens is plugged on the light strip.

In some embodiments, the sections of the light modules are divided into a first group and a second group.

The LED electrodes of the sections of the first group and the LED electrodes of the sections of the second group are separately electrically connected to the driver.

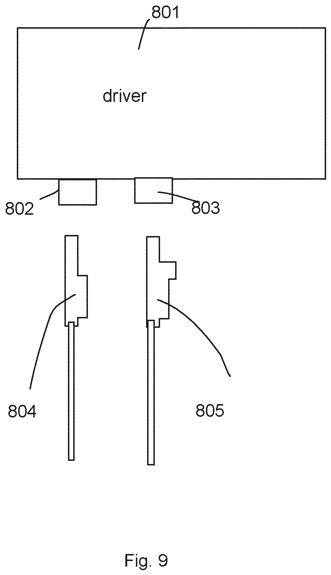

In Fig. 9, the LED units in the first group are integrated to the first connector 804. The LED units in the second group are integrated to the second connector 805.

In some embodiments, the first group is connected to a first connector and the second group is connected to a second connector.

The driver determines types of the first connector and the second connector to supply corresponding driving currents to the first group and the second group separately. The driver 801 is connected to the first connector 804 with a first terminal 802. The drive 801 is connected to the second connector 805 with the second terminal 803.

The driver 801 checks the type of the first connector 804 and the second connector 805 so as to determine a corresponding driving scheme to generate corresponding driving currents to the fist group and the second group of LED units to mix a required light parameter.

The foregoing description, for purpose of explanation, has been described with reference to specific embodiments.

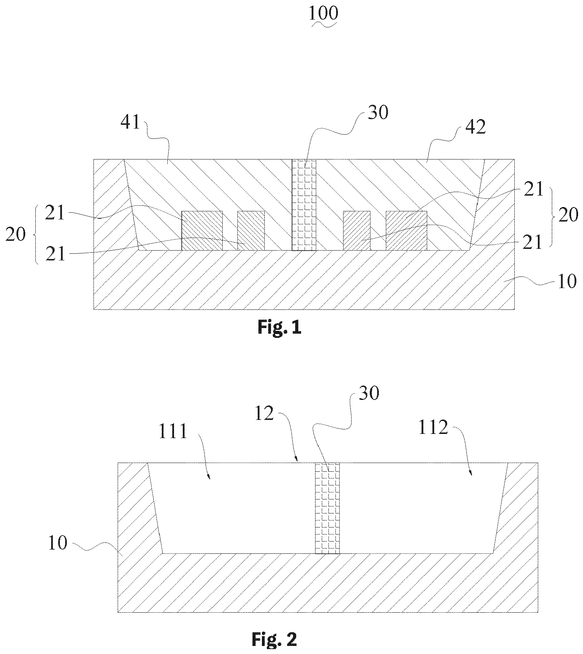

Please refer to Fig. 1. In Fig. 1, a LED package 10 has a space wall 30 to divide the LED package into a first section 41 and a second section 42. A first fluorescent layer and a second fluorescent layer are filled in the concave containers of the first section 41 and the second section 42. There are LED units 20 placed in the first section 41 and the second section 42. The LED units in the two sections respectively have two LED chips 21.

Fig. 2 show a different view of the example in Fig. 1. The same reference numerals in following drawings refer to the same components and may not be repeated for brevity.

In Fig. 2, the first section has a concave area 111 and the second section has a concave area 112 to be filled with fluorescent layers.

Fig. 3 shows a top view of the example in Fig. 1 and Fig. 2.

The two sections respectively have a positive electrode 901 and a negative electrode 902 so as to receive driving currents separately to change a relative ratio for getting a required mixed light parameter.

Fig. 4 shows a lens 50 with a dorm area 53 for placing the LED package 10. The lens has a concave curve surface 52 for diffusing and mixing lights of different sections of the LED package 10. The lens has a top exterior curve surface 51 for further diffusing the mixed lights.

Fig. 5 shows a top view of the lens 50.

Fig. 6 shows a light source plate with multiple grooves 961 for placing multiple light strips 202. Each light strip has light modules 100.

The embodiments were chosen and described in order to best explain the principles of the techniques and their practical applications. Others skilled in the art are thereby enabled to best utilize the techniques and various embodiments with various modifications as are suited to the particular use contemplated.

Although the disclosure and examples have been fully described with reference to the accompanying drawings, it is to be noted that various changes and modifications will become apparent to those skilled in the art.

## Claims

1. A lighting apparatus, comprising:
a light source plate (621);
multiple light modules (100,631) placed on the light source plate (621), wherein each light module (631) comprises a LED package (603) and a lens (606), wherein the LED package (603) comprises multiple sections, wherein at least a LED unit is placed in each section, wherein each section has a pair of corresponding LED electrodes (623, 624); and
a driver (622) electrically connected to the LED electrodes (623, 624) for supplying an adjustable ratio of separate driving currents to the LED electrodes (623, 624) to generate a required light parameter by mixing multiple lights emitted by the LED units disposed in the sections of the light modules (631),
wherein the lens has multiple lens areas for guiding lights of different sections in each light module (631) to generate a mixed light via the lens (606),
wherein the light source plate has multiple grooves for placing multiple light strips (202), and the multiple light modules are placed on the light strips (202),
furthermore comprising a light passing cover (781) connected to the light source plate forming a container for enclosing the multiple light modules,
wherein the light passing cover (781) has multiple cover lenses (784) corresponding to the multiple light strips.

2. The lighting apparatus of claim 1, wherein the LED package (603) has a first section (601) and a second section (602), wherein a first LED unit is placed in the first section (601) covered with a first fluorescent layer (651), a second LED unit is place in the second section (602) covered with a second fluorescent layer (652), wherein the first fluorescent layer (651) and the second fluorescent layer (652) have different compositions.

3. The lighting apparatus of claim 2, wherein the LED package (603) has a package housing (6031) and a spacer wall (6032), wherein the spacer wall (6032) separates the first section (601) and the second section (602),
preferably, the packaging housing (603) has tilt bases (635) for respectively placing the first LED unit and the second LED unit so that lights of the first LED unit and the second LED unit overlaps more than 50 percent in the lens (606).

4. The lighting apparatus of claim 2 or 3, wherein the first LED unit has at least one first type LED chip and one second type LED chip, wherein the second LED unit has at least one first type LED chip and one second type LED chip, wherein the driver (622) adjusts the adjustable ratio of separate driving currents to generate the required light parameter.

5. The lighting apparatus of any one of claims 2 to 4, wherein the LED package (603) has a circular external shape,
preferably, the first section (601) is semi-circular shape and the second section (602) is semi-circular shape.

6. The lighting apparatus of any one of claims 2 to 5, wherein the light module (631) has an aligning structure (605) for aligning the lens (606) with the LED package (603).

7. The lighting apparatus of any one of claims 2 to 6, wherein the lens (606) has a convex external curve surface,
preferably, the lens (606) has a concave curve inner dome facing to the LED package (603).

8. The lighting apparatus of any one of claims 2 to 7, wherein the lens (606) has multiple micro lenses for guiding lights of different sections to generate the mixed light via the lens.

9. The lighting apparatus of any one of claims 1 to 8, wherein the lens (606) has a package connector for aligning and coupling the LED package (603).

10. The lighting apparatus of claim 1, wherein the light strips (202) are detachable to be replaced from the light source plate.

11. The lighting apparatus of any one of claims 1 to 10, wherein the lens has a plugging structure for plugging on the light strip,
preferably, the LED package (603) is electrically connected to the driver (622) when the lens is plugged on the light strip.

12. The lighting apparatus of any one of claims 1 to 11, wherein the sections of the light modules are divided into a first group and a second group, wherein the LED electrodes of the sections of the first group and the LED electrodes of the sections of the second group are separately electrically connected to the driver (801).

13. The lighting apparatus of claim 12, wherein the first group is connected to a first connector (804) and the second group is connected to a second connector (805), the driver (622) determines types of the first connector (804) and the second connector (805) to supply corresponding driving currents to the first group and the second group separately.

## Patentansprüche

1. Beleuchtungsvorrichtung, die Folgendes umfasst:
eine Lichtquellenplatte (621);
mehrere Lichtmodule (100, 631), die auf der Lichtquellenplatte (621) platziert sind, wobei jedes Lichtmodul (631) ein LED-Paket (603) und eine Linse (606) umfasst, wobei das LED-Paket (603) mehrere Abschnitte umfasst, wobei in jedem Abschnitt mindestens eine LED-Einheit platziert ist, wobei jeder Abschnitt ein Paar entsprechender LED-Elektroden (623, 624) aufweist; und
einen Treiber (622), der elektrisch mit den LED-Elektroden (623, 624) verbunden ist, um den LED-Elektroden (623, 624) ein einstellbares Verhältnis separater Treiberströme zuzuführen, um durch Mischen mehrerer von den in den Abschnitten der Lichtmodule (631) angeordneten LED-Einheiten emittierten Lichtern einen erforderlichen Lichtparameter zu erzeugen,
wobei die Linse mehrere Linsenbereiche zum Leiten von Licht unterschiedlicher Abschnitte in jedem Lichtmodul (631) aufweist, um über die Linse (606) ein gemischtes Licht zu erzeugen,
wobei die Lichtquellenplatte mehrere Nuten zum Platzieren mehrerer Lichtstreifen (202) aufweist und die mehreren Lichtmodule auf den Lichtstreifen (202) platziert sind, ferner umfassend eine lichtdurchlässige Abdeckung (781), die mit der Lichtquellenplatte verbunden ist und einen Behälter zum Umschließen der mehreren Lichtmodule bildet,
wobei die lichtdurchlässige Abdeckung (781) mehrere Abdecklinsen (784) aufweist, die den mehreren Lichtstreifen entsprechen.

2. Beleuchtungsvorrichtung nach Anspruch 1, wobei das LED-Paket (603) einen ersten Abschnitt (601) und einen zweiten Abschnitt (602) aufweist, wobei eine erste LED-Einheit im ersten Abschnitt (601) platziert ist, den eine erste fluoreszierende Schicht (651) bedeckt, wobei eine zweite LED-Einheit im zweiten Abschnitt (602) platziert ist, den eine zweite fluoreszierende Schicht (652) bedeckt, wobei die erste fluoreszierende Schicht (651) und die zweite fluoreszierende Schicht (652) unterschiedliche Zusammensetzungen aufweisen.

3. Beleuchtungsvorrichtung nach Anspruch 2, wobei das LED-Paket (603) ein Paketgehäuse (6031) und eine Abstandshalterwand (6032) aufweist, wobei die Abstandshalterwand (6032) den ersten Abschnitt (601) und den zweiten Abschnitt (602) voneinander trennt,
wobei das Verpackungsgehäuse (603) vorzugsweise geneigte Unterteile (635) zum jeweiligen Platzieren der ersten LED-Einheit und der zweiten LED-Einheit aufweist, sodass sich das Licht der ersten LED-Einheit und der zweiten LED-Einheit in der Linse (606) um mehr als 50 Prozent überlappt.

4. Beleuchtungsvorrichtung nach Anspruch 2 oder 3, wobei die erste LED-Einheit mindestens einen LED-Chip einer ersten Art und einen LED-Chip einer zweiten Art aufweist, wobei die zweite LED-Einheit mindestens einen LED-Chip der ersten Art und einen LED-Chip der zweiten Art aufweist, wobei der Treiber (622) das einstellbare Verhältnis der separaten Treiberströme einstellt, um den erforderlichen Lichtparameter zu erzeugen.

5. Beleuchtungsvorrichtung nach einem der Ansprüche 2 bis 4, wobei das LED-Paket (603) eine kreisförmige Außenform aufweist,
wobei der erste Abschnitt (601) und der zweite Abschnitt (602) vorzugsweise halbkreisförmig sind.

6. Beleuchtungsvorrichtung nach einem der Ansprüche 2 bis 5, wobei das Lichtmodul (631) eine Ausrichtungsstruktur (605) zum Ausrichten der Linse (606) mit dem LED-Paket (603) aufweist.

7. Beleuchtungsvorrichtung nach einem der Ansprüche 2 bis 6, wobei die Linse (606) eine konvexe gekrümmte Außenfläche aufweist,
wobei die Linse (606) vorzugsweise eine konkav gekrümmte Innenkuppel aufweist, die zum LED-Paket (603) zeigt.

8. Beleuchtungsvorrichtung nach einem der Ansprüche 2 bis 7, wobei die Linse (606) mehrere Mikrolinsen zum Leiten von Licht unterschiedlicher Abschnitte aufweist, um über die Linse das gemischte Licht zu erzeugen.

9. Beleuchtungsvorrichtung nach einem der Ansprüche 1 bis 8, wobei die Linse (606) einen Paketverbinder zum Ausrichten und Koppeln des LED-Pakets (603) aufweist.

10. Beleuchtungsvorrichtung nach Anspruch 1, wobei die Lichtstreifen (202) abnehmbar sind, um auf der Lichtquellenplatte ausgetauscht zu werden.

11. Beleuchtungsvorrichtung nach einem der Ansprüche 1 bis 10, wobei die Linse eine Steckstruktur zum Aufstecken auf den Lichtstreifen aufweist,
wobei das LED-Paket (603) vorzugsweise elektrisch mit dem Treiber (622) verbunden ist, sobald die Linse auf den Lichtstreifen gesteckt ist.

12. Beleuchtungsvorrichtung nach einem der Ansprüche 1 bis 11, wobei die Abschnitte der Lichtmodule in eine erste Gruppe und eine zweite Gruppe unterteilt sind, wobei die LED-Elektroden der Abschnitte der ersten Gruppe und die LED-Elektroden der Abschnitte der zweiten Gruppe separat elektrisch mit dem Treiber (801) verbunden sind.

13. Beleuchtungsvorrichtung nach Anspruch 12, wobei die erste Gruppe mit einem ersten Verbinder (804) verbunden ist und die zweite Gruppe mit einem zweiten Verbinder (805) verbunden ist, wobei der Treiber (622) die Art des ersten Verbinders (804) und des zweiten Verbinders (805) ermittelt, um der ersten Gruppe und der zweiten Gruppe separat entsprechende Treiberströme zuzuführen.

## Revendications

1. Appareil d'éclairage, comprenant :
une plaque source de lumière (621) ;
de multiples modules de lumière (100, 631) placés sur la plaque source de lumière (621), dans lequel chaque module de lumière (631) comprend un boîtier de DEL (603) et une lentille (606), dans lequel le boîtier de DEL (603) comprend de multiples sections, dans lequel au moins une unité DEL est placée dans chaque section, dans lequel chaque section comporte une paire d'électrodes DEL correspondantes (623, 624) ; et
un circuit d'attaque (622) connecté électriquement aux électrodes DEL (623, 624) pour fournir un rapport réglable de courants d'attaque séparés aux électrodes DEL (623, 624) pour générer un paramètre de lumière requis en mélangeant de multiples lumières émises par les unités DEL disposées dans les sections des modules de lumière (631),
dans lequel la lentille comporte de multiples zones de lentille pour guider les lumières de différentes sections dans chaque module de lumière (631) pour générer une lumière mixte par l'intermédiaire de la lentille (606),
dans lequel la plaque source de lumière comporte de multiples rainures pour placer de multiples bandes de lumières (202), et les multiples modules de lumière sont placés sur les bandes de lumière (202), comprenant en outre un couvercle de passage de lumière (781) relié à la plaque source de lumière formant un récipient pour enfermer les multiples modules de lumière,
dans lequel le couvercle de passage de lumière (781) comporte de multiples lentilles de couvercle (784) correspondant aux multiples bandes de lumière.

2. Appareil d'éclairage selon la revendication 1, dans lequel le boîtier de DEL (603) comporte une première section (601) et une seconde section (602), dans lequel une première unité DEL est placée dans la première section (601) recouverte d'une première couche fluorescente (651), une seconde unité DEL est placée dans la seconde section (602) recouverte d'une seconde couche fluorescente (652), dans lequel la première couche fluorescente (651) et la seconde couche fluorescente (652) ont des compositions différentes.

3. Appareil d'éclairage selon la revendication 2, dans lequel le boîtier de DEL (603) comporte un logement de boîtier (6031) et une paroi d'espaceur (6032), dans lequel la paroi d'espaceur (6032) sépare la première section (601) et la seconde section (602),
de préférence, le logement de boîtier (603) comporte des bases inclinables (635) pour placer respectivement la première unité DEL et la seconde unité DEL de sorte que les lumières de la première unité DEL et de la seconde unité DEL se chevauchent à plus de 50 pour cent dans la lentille (606).

4. Appareil d'éclairage selon la revendication 2 ou 3, dans lequel la première unité DEL comporte au moins une puce DEL de premier type et une puce DEL de second type, dans lequel la seconde unité DEL comporte au moins une puce DEL de premier type et une puce DEL de second type, dans lequel le circuit d'attaque (622) règle le rapport réglable de courants d'attaque séparés pour générer le paramètre de lumière requis.

5. Appareil d'éclairage selon l'une quelconque des revendications 2 à 4, dans lequel le boîtier de DEL (603) a une forme externe circulaire,
de préférence, la première section (601) est de forme semi-circulaire et la seconde section (602) est de forme semi-circulaire.

6. Appareil d'éclairage selon l'une quelconque des revendications 2 à 5, dans lequel le module de lumière (631) a une structure d'alignement (605) pour aligner la lentille (606) avec le boîtier de DEL (603).

7. Appareil d'éclairage selon l'une quelconque des revendications 2 à 6, dans lequel la lentille (606) a une surface courbe externe convexe,
de préférence, la lentille (606) a un dôme intérieur courbe concave faisant face au boîtier de DEL (603).

8. Appareil d'éclairage selon l'une quelconque des revendications 2 à 7, dans lequel la lentille (606) comporte de multiples micro-lentilles pour guider les lumières de différentes sections afin de générer la lumière mixte par l'intermédiaire de la lentille.

9. Appareil d'éclairage selon l'une quelconque des revendications 1 à 8, dans lequel la lentille (606) comporte un connecteur de boîtier pour aligner et coupler le boîtier de DEL (603).

10. Appareil d'éclairage selon la revendication 1, dans lequel les bandes de lumière (202) sont détachables pour être remplacées de la plaque source de lumière.

11. Appareil d'éclairage selon l'une quelconque des revendications 1 à 10, dans lequel la lentille a une structure de fiche pour se brancher sur la bande de lumière,
de préférence, le boîtier de DEL (603) est connecté électriquement au circuit d'attaque (622) lorsque la lentille est branchée sur la bande de lumière.

12. Appareil d'éclairage selon l'une quelconque des revendications 1 à 11, dans lequel les sections des modules de lumière sont divisées en un premier groupe et un second groupe, dans lequel les électrodes DEL des sections du premier groupe et les électrodes DEL des sections du second groupe sont connectées électriquement séparément au circuit d'attaque (801).

13. Appareil d'éclairage selon la revendication 12, dans lequel le premier groupe est connecté à un premier connecteur (804) et le second groupe est connecté à un second connecteur (805), le circuit d'attaque (622) détermine les types du premier connecteur (804) et du second connecteur (805) pour alimenter en courants d'attaque correspondants le premier groupe et le second groupe séparément.
